# EUROPEAN PATENT APPLICATION

(11) **EP 1 024 603 A2**
(43) Date of publication of application: **02.08.2000**
(21) Application number: 00300540.2
(22) Date of filing: 25.01.2000
(51) Int. Cl.: H03M 13/41

(54) **Method and apparatus to increase the speed of Viterbi decoding**

(30) Priority: 27.01.1999 US 117485 P
(71) Applicant: TEXAS INSTRUMENTS INCORPORATED, Dallas Texas 75265 (US)
(72) Inventor: Hendrix, Henry D., Roswell, Georgia 30076 (US)
(74) Representative: Legg, Cyrus James Grahame

(57) **Abstract**

A system (10) for decoding convolutionally-encoded data (12) is provided. The system comprises a branch metric calculator (14) operable to calculate the branch metric for each received data symbol (12). The system (10) further includes an add-compare-select calculator (16) coupled to the branch metric calculator (14) and operable to calculate an updated path metric and a delay state transition value for each delay state. The updated path metrics are calculated by first organizing the delay states by branch metric value and then calculating all path metric updates for that branch metric. The process is continued for all other branch metrics. A traceback calculator (20) is used to trace back along the optimal path to extract the decoded data (24).

## Description

### TECHNICAL FIELD OF THE INVENTION

This invention relates to error correction coding and decoding and more specifically to a method and apparatus to increase the speed of Viterbi decoding.

### BACKGROUND OF THE INVENTION

In many different applications, including modems and wireless communication systems, error correction coding is required to overcome distortions in transmissions. These error correction systems are typically implemented on digital signal processors (DSPs) such as the TMS320C54x family of digital signal processors manufactured by Texas Instruments, Incorporated.

The preferred method of error-correction coding is through convolution coding. Convolution coding is a bit-level encoding technique (as opposed to block-level encoding techniques such as Reed-Soloman coding). Convolution codes are decoded using a trellis decoding method. One type of trellis decoding method is the Viterbi decoding method.

In convolution coding, an output results from convolving an incoming bit with previous unencoded bits. Error correction is dependent on the number of past samples that form the code symbols. Typically, the more past samples, the better the encoding. The constraint length is the number of input bits used in the encoding process and is the number of delay units plus one.

The other factor of concern in error correction is the coding rate. The coding rate is the ratio of input data bits to bits transmitted. In a typical example, the coding rate is 1/2 which means two bits are transmitted for every one input bit.

Convolutionally-encoded data is decoded through the knowledge of the possible state transitions which are created from the dependence of the current symbol on past data. The allowable states can be represented by the use of a trellis diagram. The number of possible states can be found by raising two to the power of the constraint length minus one.

The Viterbi algorithm provides a method for minimizing the number of potential data-symbol sequences (trellis paths) by identifying the code sequences that have the highest probability of matching the transmitted sequence based on the received sequence. The Viterbi algorithm consists of two parts -- a metric update and a traceback routine. In a metric update, probabilities are accumulated for all states based on the current input symbol. The traceback routine reconstructs the data once an optimal path through the trellis is identified.

In the metric update, the Viterbi algorithm must calculate the most likely previous state for all possible states. Each delay state is linked to previous states by a subset of possible paths. The Viterbi algorithm calculates the accumulated distance along each path and retains an indicator of the path with the smallest distance and its updated metric. The metric update is done for each state. This process is known as the add-compare-select operation: distance data is accumulated, the various paths are compared and the most likely path is chosen. For each delay state, both an updated path metric and a transition entry are saved. To increase the speed of the process, symmetrical trellis paths known as butterflies can be calculated. Butterfly structures occur because in 1/n rate encoders the path states leading to a delay state are complementary. Therefore two start states and ending states can be grouped together and the four transitions have the required symmetry. For each butterfly calculation there is only one local distance to be calculated.

In the traceback step, the delay states are decoded into the original data by tracing backwards through the most likely paths of the trellis as indicated by the transition table. In operation, the system either waits for an entire frame of data or traces back after receiving a certain amount of data.

In operation, the Viterbi algorithm can be slow, especially in the metric update section where the different paths are evaluated.

### SUMMARY OF THE INVENTION

Accordingly, it may be appreciated that a need has arisen for a method and apparatus to increase the speed of Viterbi decoding. In accordance with the teaching of the present invention, a method and apparatus to increase the speed of Viterbi decoding is provided that substantially eliminates or reduces the disadvantages of previous methods.

In one embodiment, a system for decoding convolutionally-encoded data is provided. The system comprises a branch metric calculator operable to calculate the local distance between each received symbol and the expected path state. The system further includes an add-compare-select calculator coupled to the branch metric calculator and operable to calculate an updated path metric. The updated path metric is calculated by first organizing the delay states by branch metric value and then calculating all path metric updates for that branch metric. The process is continued for all other branch metrics.

The present invention provides various technical advantages over current methods. For example, Viterbi decoding can be done in a more efficient manner. Other technical advantages may be readily apparent to one skilled in the art from the following figures, descriptions and claims.

### BRIEF DESCRIPTION OF THE DRAWINGS

For a more complete understanding of the present invention and advantages thereof, reference is now made to the following descriptions taken in conjunction with the accompanying drawings, in which like numbers represent like parts, in which:
FIGURE 1 illustrates a system for decoding convolutionally-encoded data in accordance with the teachings of the present invention; and,
FIGURE 2 is a flowchart outlining the operation of an embodiment of the present invention.

### DETAILED DESCRIPTION OF THE INVENTION

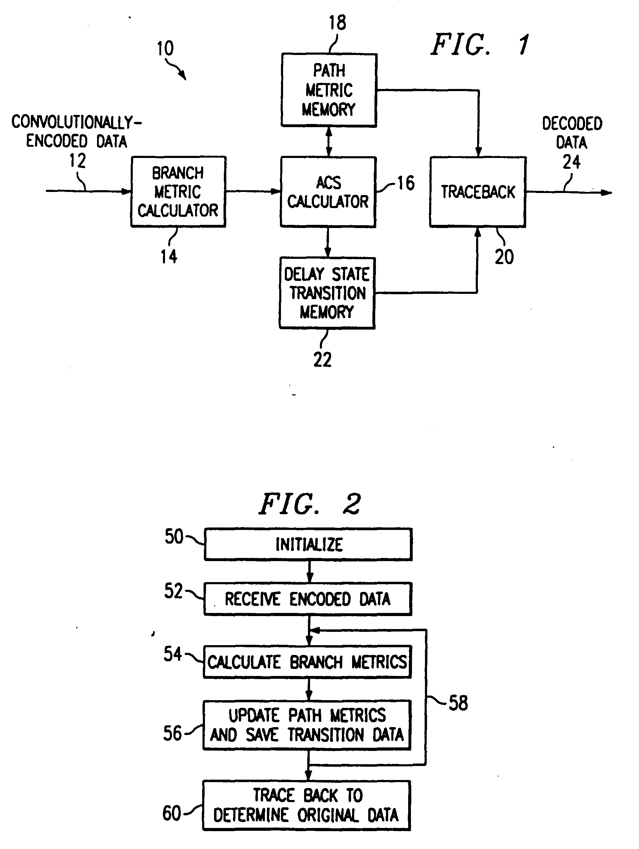

Embodiments of the present invention and its advantages are best understood by referring to FIGURES 1 through 2 of the drawings, like numerals being used for like and corresponding parts of the various drawings.

FIGURE 1 illustrates a system for decoding convolutionally-encoded data in accordance with the teachings of the present invention. Decoding system 10 is shown as an exemplary system. The blocks used to show individual components are examples only. These blocks can be implemented as processors, memories and logic functions. In one embodiment, the capabilities of system 10 can be implemented on a digital signal processor, such as the TMS320C54X, manufactured by Texas Instruments, Inc.

Decoding system 10 includes a branch metric calculator 14, an add/compare/select calculator 16, a path metric memory 18, a traceback calculator 20 and a delay state transition memory 22.

In operation, incoming convolutionally-encoded data 12 is received at branch metric calculator 14. Convolutionally-encoded data 12 can be data received by a wireless communication system, data received by a modem, data received by a read/write head of a hard drive or any other source of bit convolved data. Branch metric calculator 14 is operable to take the incoming convolutionally-encoded data symbol and calculate how far that symbol is from what was expected for each path. This is known as the branch metric. The number of branch metrics that need to be calculated is based on the rate of the encoded data. If the convolutionally-encoded data 12 was encoded in a ½ rate system, four different branch metrics would be calculated. Two of the branch metrics will be inverses of the other two. In general, for a 1/n rate system, there are 2ⁿ possible branch metrics with 2ⁿ⁻¹ different magnitude. For a ½ rate encoder (i.e. for a ½ rate encoder, there are 2 positive and 2 negative).

After branch metrics are calculated for a given data symbol, this information is used by ACS 16. As discussed previously, for a ½ rate decoder there are a total of four branch metric calculations that need to be made. Of the four, two are unique and the other two are inverses of the first two. After the branch metrics for a given received symbol are calculated, the branch metrics will be used to calculate updated path metrics for each state. In a typical Viterbi scheme, metric updates are calculated in order of delay states and the branch metrics are calculated when needed. In the present invention, the metric updates are calculated in order of branch metrics with the delay states accessed in non-consecutive order. The states are accessed as butterflies to speed the process. All the state pairs with the same branch metric are calculated together. In this way, each branch metric is calculated once, then all the butterflies associated with it are calculated. Next, all the butterflies that use the inverse of that branch metric can be calculated. Then, the next branch metric and its inverse are used.

The number of butterflies that need to be calculated depends on the constraint length of the encoder. The larger the constraint length, the larger the number of states. As discussed earlier, the number of delay states is equal to two raised to the power of the constraint length minus one. Thus, the number of states for an encoder with a constraint length of nine is 256. The number of butterflies to be calculated will thus be 128. In the case of a ½ rate encoder, there will be four different branch metrics to calculate. Thus there will be 32 butterflies associated with each branch metric. Once the first branch metric is determined, all the butterflies for that branch metric are calculated. As each set of butterflies are calculated, the updated path metrics are stored in path metric memory 18. Also, as the butterflies are calculated, an indication of the selected paths is stored in transition data memory 20.

The transition data stored in transition memory 22 is used to show what order to remove bits during traceback. Therefore, the traceback routine implemented by traceback calculator 20 uses transition memory 22 to determine the most likely path back to the beginning of the trellis. Except for the scrambled order of the transition memory 22, due to the processing of butterflies in a different order, to track the correct order of the traceback, traceback occurs as discussed in the background. The entire process -- determining branch metrics, performing the metric update for all butterflies with the same branch metric, repeating the calculation for each branch metric -- occurs for each and every received data symbol. Traceback typically occurs after a large number of symbols have been processed.

FIGURE 2 is a flowchart outlining the operation of an embodiment of the present invention. In step 50, any initialization procedures are executed. These would include setup procedures necessary to implement the present invention on a specific digital signal processor. Next, encoded data is received in step 52. This data is received, in one embodiment, by a digital signal processor.

In step 54, the branch metric is calculated for the current received data symbol. The branch metric is a measure of how far apart an incoming bit of data is from an expected value. As discussed earlier, the rate of the encoder determines the number of branch metrics that need be calculated. In an exemplary 1/2 rate system, there are four possible branch metric values. In step 56, these branch metrics are used to calculate the updated path metric for each possible delay state. Both the updated path metric and the transition data are stored to memory. In the present invention, all delay states are updated in order of branch metrics. This means that all delay states with the same branch metric are updated at once, followed by the delay states associated with the next branch metric, and so on for all the branch metrics in that system. Calculating path metrics in order of branch metrics increases the efficiency of the system by decreasing the number of times the branch metrics have to be accessed.

This is repeated for all the branch metrics and incoming data, which is illustrated by loop 58. In step 60, a traceback procedures is implemented to recover the original data bits.

Although the present invention has been described in detail, it should be understood that various changes, substitutions and alterations can be made thereto without departing from the spirit and scope of the invention as defined by the appended claims.

## Claims

1. A system for decoding convolutionally-encoded data comprising:
a branch metric calculator operable to receive convolutionally-encoded data and calculate branch metrics for the data;
a path metric calculator coupled to the branch metric calculator and operable to calculate a plurality of updated path metrics based on the branch metrics, wherein the plurality of updated path metrics are calculated in groups determined by the branch metric.

2. The system of claim 1, further comprising a traceback calculator coupled to the path metric calculator and operable to trace back through delay states to determine the original, unencoded data.

3. The system of Claim 2, further comprising a delay state transition memory coupled to the traceback calculator and operable to be accessed by the traceback calculator to assist in extracting the unencoded data.

4. The system of any one of claims 1 to 3, wherein a path metric memory is coupled to the path metric calculator and is operable to store the updated path metrics.

5. The system of any one of claims 1 to 4, wherein the total number of delay states is determined by raising two to the power of a constraint length of an original encoder minus one.

6. The system of any one of claim 1 to 5, wherein the number of possible branch metrics is determined by the rate of the encoder.

7. The system of any one of claim 1 to 6, wherein the number of possible branch metrics for a 1/n rate encoder is equal to 2ⁿ.

8. A system as claimed in any one of claims 1 to 7, wherein the path metric calculator is an add-compare-select calculator.

9. A system as claimed in any one of claims 1 to 8, wherein all the state pairs with the same branch metric are calculated together in a group.

10. A system as claimed in claim 1, wherein the path metric calculator is capable of using the branch metric information to determine path metric and delay state transition for the received data, path metrics and delay state transitions for received data giving rise to the same branch metric being determined together.

11. A system as claimed in claim 10, including:
storage means connected to the path metric calculator for storing the path metric information and the delay state transition information and
traceback calculation means connected to the storage means capable of generating decoded data from the path metric information and the delay state transition information.

12. A system as claimed in claim 11, wherein the path metric calculator is capable of first determining a first set of path metrics and delay state transitions for received data giving rise to the same branch metric and then determining a second set of path metrics and delay state transitions dependent on the inverse of the branch metrics for the received data.

13. A system as claimed in claim 11 or claim 12, wherein the traceback calculation means is capable of following the order in which the delay state transition information is stored in the storage means in determining a most likely path back through the stored information for generating the decoded data.
